# EUROPÄISCHE PATENTSCHRIFT

(11) **EP 0 981 864 B1**
(45) Veröffentlichungstag und Bekanntmachung des Hinweises auf die Patenterteilung: **19.05.2004**
(21) Anmeldenummer: 99911581.9
(22) Anmeldetag: 01.02.1999
(51) Int. Cl.: H04B 1/30, H04L 25/06, H03D 7/16

(54) **INTEGRIERBARE FUNKEMPFÄNGERSCHALTUNG FÜR FREQUENZMODULIERTE DIGITALE SIGNALE**
INTEGRABLE RADIO RECEIVER CIRCUIT FOR FREQUENCY-MODULATED DIGITAL SIGNALS
CIRCUIT RADIORECEPTEUR INTEGRABLE DESTINE A DES SIGNAUX NUMERIQUES MODULES EN FREQUENCE

(30) Priorität: 11.03.1998 DE 19810558
(43) Veröffentlichungstag der Anmeldung: 01.03.2000
(73) Patentinhaber: Infineon Technologies AG, 81669 München (DE)
(72) Erfinder: HEINEN, Stefan, D-47802 Krefeld (DE)
(74) Vertreter: Epping, Hermann, Fischer
(86) Internationale Anmeldenummer: PCT/DE1999/000267
(87) Internationale Veröffentlichungsnummer: WO 1999/046864

(56) Entgegenhaltungen:
- EP-A- 0 153 020
- WO-A-93/14578
- DE-A- 19 612 714
- GB-A- 1 530 602

## Beschreibung

Die Erfindung bezieht sich auf eine integrierbare Funkempfängerschaltung gemäß dem Oberbegriff des Patentanspruchs 1.

Beim Funkrufdienst, der auch als Paging Service bezeichnet wird, werden für die Funkrufempfänger, also für die sogenannten Pager, analoge Homodynempfänger eingesetzt. Aufgrund der bei diesem Dienst verwendeten Frequenzmodulation (FM) kann in einem solchen Empfänger eine Wechselstromkopplung ("AC"-Kopplung) zur Unterdrückung von statischen und dynamischen Offsetspannungen eingesetzt werden.

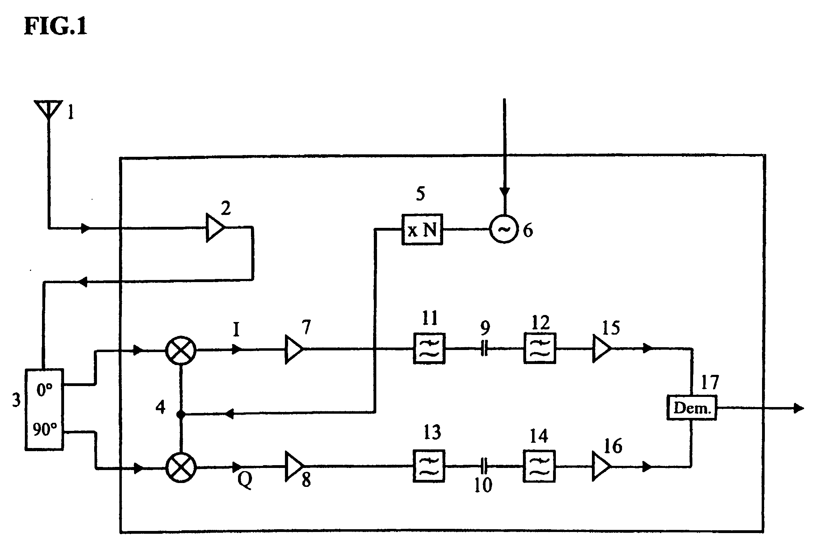

Eine bekannte, in einem einzigen Chip integrierte Schaltung eines in einem Pager verwendeten Homodynempfängers ist in Blockschaltbildform in FIG. 1 dargestellt. Eine solche Schaltung wurde zum Beispiel von J. Wilson, R. Youell, T. Richards, G. Luff, R. Pilaski in dem Aufsatz "A Single Chip VHF and UHF Receiver for Radio Paging" in IEEE Journal of Solid State Circuits, Vol. 26, No. 12, Dezember 1991 beschrieben.

Hierbei wird das von einer Antenne 1 kommende HF-Empfangssignal nach Verstärkung in einem HF-Verstärker 2 und nach einer Aufteilung in zwei um 90° phasenversetzte Signale durch ein Phasenglied 3 den beiden ersten Eingängen eines Quadraturabwärtsmischer 4 zugeführt, an dessen beiden zweiten Eingängen das Ausgangssignal eines in einem Frequenzvervielfacher 5 vervielfachten HF-Oszillators 6 liegt.

Eine Kanalfilterung erfolgt im Anschluß an eine Verstärkung in Verstärkern 7 und 8 durch integrierte, mittels eines Kondensators 9 bzw. 10 miteinander wechselstromgekoppelte Tiefpaßfilter 11, 12 im I-Pfad und durch integrierte Tiefpaßfilter 13, 14 im Q-Pfad. Die Signale im I- und Q-Pfad werden getrennt über jeweils einen begrenzenden Verstärker 15 bzw. 16 einem analogen Demodulator 17 ("Quadrikorrelator") zugeführt, an dessen Ausgang dann das demodulierte Ausgangssignal zur Anzeige abgenommen werden kann.

Für Funksysteme, die mit GFSK("Gaussian Frquency Shift Keying")- bzw. GMSK("Gaussian Minimum Shift Keying")-Modulation arbeiten, ist eine Wechselstromkopplung nicht möglich, da die Hauptenergie des entsprechend modulierten Signals bei niedrigen Frequenzen konzentriert ist.

Aus dem Buch von J. Crols und M. Steyaert: "CMOS Wireless Transceiver Design", 1997, Kluwer Academic Publishers, Seiten 52 bis 67 sowie Seiten 114 und 115, ist in diesem Zusammenhang für das GSM-Mobilfunksystem, bei dem mit GMSK-Modulation gearbeitet wird, ein mit niedriger Zwischenfrequenz ("Low-IF") betriebener Empfänger mit digitaler Demodulation bekannt.

Für die digitale Demodulation wird ein linearer Signalpfad bis zu den Analog/Digital-Wandlern benötigt, die bei Anwendung im Rahmen eines DECT("Digital European Cordless Communications")-Systems eine Auflösung von 12-13 Bit bei einer Bandbreite von ca. 800 kHz (Bandpaßwandler) haben sollten. Dies ist jedoch in den augenblicklich verfügbaren Technologien nur mit erheblichem Aufwand und damit hohen Kosten realisierbar.

Der Erfindung liegt die Aufgabe zugrunde, für den Empfang frequenzmodulierter digitaler Funksignale, also insbesondere von FSK-, MSK-, GFSK- und GMSK-modulierten Signalen, eine Empfängerschaltung anzugeben, bei der zum einen statische und dynamische Offsetspannungen sicher unterdrückt werden und bei der man zum anderen ohne einen linearen Signalpfad bis zu den Analog/Digital-Wandlern auskommt, so daß sich der technische Aufwand erheblich reduzieren läßt. Dabei soll sich der Empfänger in hochintegrierter Bauweise ohne Einsatz externer ZF-Filter erstellen lassen.

Die genannte Aufgabe wird bei einer gattungsgemäßen Funkempfängerschaltung durch die im kennzeichnenden Teil des Patentanspruchs 1 angegebenen Merkmale gelöst.

Aufgrund der Verwendung des Low-IF Konzepts können Wechselstromkopplungen verwendet werden. Die einen hohen technischen Aufwand erfordernden Ansprüche an Linearität des Signalpfades müssen nicht mehr gestellt werden. Es lassen sich dann integrierbare analoge Filter und ein ebenfalls gut integrierbarer analoger Demodulator einsetzen.

Auch die nachfolgende Entscheiderschaltung kann integriert werden, so daß sich die Funkempfängerschaltung nach der Erfindung insgesamt in einer hochintegrierten Bauweise realisieren läßt. Bei der Funkempfängerschaltung nach der Erfindung ergibt sich also eine Kombination der vorteilhaften Eigenschaften der beiden gewürdigten Arten von Empfangsschaltungen.

Zweckmäßige Weiterbildungen sowie vorteilhafte Ausführungsund Anwendungsmöglichkeiten einer Funkempfängerschaltung nach der Erfindung sind in den Unteransprüchen angegeben.

Die Erfindung wird im folgenden anhand von Zeichnungen erläutert. Es zeigen:
FIG. 1 die bereits erläuterte bekannte Schaltung eines Pagers in Blockschaltbildform, und
FIG. 2 ein Ausführungsbeispiel einer hoch integrierbaren Funkempfängerschaltung nach der Erfindung ebenfalls in Blockschaltbildform.

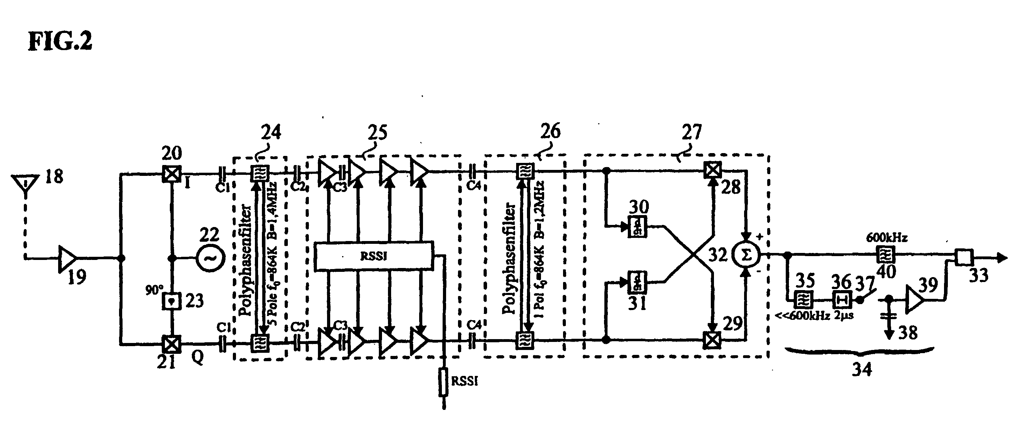

In der in der FIG. 2 dargestellten Funkempfängerschaltung, die sich z.B. bei einem mit GMSK-Modulation arbeitenden DECT-System verwenden läßt, wird das von einer Antenne 18 kommende digital frequenzmodulierte UHF-Empfangssignal nach seiner Verstärkung in einem UHF-Verstärker 19 jeweils den ersten Eingängen zweier Abwärtsmischer 20 und 21 zugeführt. Als Überlagerungssignal wird dem Abwärtsmischer 20 das Ausgangssignal eines gewöhnlich durch einen Frequenzsynthesizer realisierten UHF-Oszillators 22 unmittelbar und dem Abwärtsmischer 21 über ein 90°-Phasenglied 23 zugeleitet.

Die Abwärtsmischer 20 und 21, der UHF-Oszillator 22 und das 90°-Phasenglied 23 führen somit eine sogenannte Quadraturabwärtsmischung durch, bei der das Mischausgangssignal in zwei Quadratursignalpfaden I und Q abgenommen wird. Die Abwärtsmischung erfolgt in eine niedrige ZF(Low-IF)-Lage. Zur Kanalfilterung sind selbstkalibrierende analoge Polyphasenfilter 24 oder auch G_{M}C-Filter vorgesehen.

Danach werden die Signale im I- und Q-Pfad in einem begrenzenden Verstärker, einem sogenannten Limiter 25, verstärkt. Dies ist möglich, da in der niedrigen ZF-Lage noch eine Trägerfrequenz vorhanden ist. Bei Verwendung in einem DECT-System können die Frequenzen zwischen 864 kHz und 1728 kHz liegen. Nach einem weiteren Polyphasenfilter 26 oder einem weiteren G_{M}C-Filter zur Unterdrückung der im Limiter 25 entstandenen Oberwellen werden die Signale im I- und Q- Quadratursignalpfad einem analogen Quadratursignaldemodulator, d.h. im Ausführungsbeispiel einem sogenannten Quadrikorrelator 27, zugeführt.

In dem in FIG. 2 dargestellten Ausführungsbeispiel sind zur Wechselstromkopplung ("AC"-Kopplung) in den beiden Quadratursignalpfaden I und Q an mehreren Schaltungsstellen kapazitive Kopplungen in Form von seriell eingeschalteten Kapazitäten C1, C2, C3 und C4 vorgesehen, die paarweise jeweils gleich groß bemessen sind. Statische und dynamische Offsetspannungen werden durch diese Kapazitäten sicher unterdrückt.

Der aus zwei Mischern 28, 29, zwei Differenziergliedern 30, 31 und einem Summierglied 32 zusammengesetzte Quadrikorrelator 27 erzeugt am Ausgang eine differentielle Spannung, die proportional zu seiner Eingangsfrequenz ist. Aufgrund der Zwischenfrequenz von beispielsweise 864 kHz tritt somit durch die Modulation und zugelassene Frequenzoffsets eine maximale Eingangsfrequenz von ca. 1,6 MHz auf. Der Quadrikorrelator 27 muß somit eine Bandbreite von ±1,6 MHz besitzen.

Der Absolutwert der Ausgangsspannung des Quadrikorrelators 27 für die nominale Zwischenfrequenz hängt von Schwankungen der Technologieparameter ab. Die Ausgangsspannung des Quadrikorrelators 27 wird als Auswertungsgrundlage für die den jeweiligen binären Zustand des empfangenen Signals betreffenden Entscheidungen einer Entscheiderschaltung 33 herangezogen.

Bei der Festlegung der Entscheiderschwelle für die Entscheiderschaltung 33 muß zusätzlich noch ein möglicher Frequenzoffset berücksichtigt werden. Nach der Entscheiderschaltung 33 liegen dann die digitalen Daten an.

Bei einem DECT-System wird am Anfang eines Bursts eine binäre "1010"-Sequenz von 16 Bit Länge, gefolgt von einer zweifachen binären "1", gesendet. Diese besondere Sequenz kann, wie das in FIG. 2 dargestellte Ausführungsbeispiel zeigt, mit Hilfe einer Abtast- und Halteschaltung 34 zur Generierung der Entscheiderschwelle genutzt werden. Dazu wird das im Quadrikorrelator 27 demodulierte Signal in einem Tiefpaß 35 tiefpaßgefiltert und im Anschluß daran mittels eines Verzögerungsgliedes 36 verzögert.

Die Grenzfrequenz des Tiefpasses 35 liegt deutlich unterhalb der Modulationsfrequenz. Daraus ergibt sich dann der Mittelwert des Signals während der beschriebenen charakteristischen "1010"-Binärsequenz. Dieser Mittelwert wird dann in einem über einen Abtastschalter 37 zu ladenden Querkondensator 38 gespeichert und über eine hochohmige Pufferverstärkerstufe 39 an einen Stelleingang der Entscheiderschaltung 33 zur Einstellung der Entscheiderschwelle zugeführt.

Über einen Parallelpfad, der einen Tiefpaß 40 enthält, wird das vom Quadrikorrelator 27 demodulierte Signal der Entscheiderschaltung 33 zugeführt. Die Grenzfrequenz des Tiefpasses 40 in diesem Pfad liegt oberhalb der maximalen Modulationsfrequenz. Während des Abtastvorganges wird somit die Entscheiderschwelle eingestellt.

Wird im Digitalteil die zweifache binäre "1" eines DECT-Bursts erkannt, wird der Abtastschalter 37 geöffnet, der bei Erkennen des Beginns der charakteristischen "1010"-Binärsequenz eines Bursts stets geschlossen wird. Aufgrund des Verzögerungsgliedes 36 hat jedoch die zweifache "1" noch keinen Einfluß auf die Spannung des Querkondensators 38.

## Patentansprüche

1. Integrierbare Funkempfängerschaltung für frequenzmodulierte digitale Signale mit Quadratur-Abwärtsmischung des über eine Antenne empfangenen HF-Signals in eine niedrige ZF-Lage, einer der Abwärtsmischung folgenden ZF-Kanalfilterung mittels analoger Polyphasenfilter in den beiden Quadratursignalpfaden und einem nachfolgenden Quadratursignaldemodulator, **dadurch gekennzeichnet,**
**daß** in den beiden Quadratursignalpfaden (I, Q) eine Wechselstromkopplung (C1, C2, C3, C4) vorgesehen ist und
**daß** der Quadratursignaldemodulator (27) ein analoger Demodulator ist, der an seinem Ausgang eine Spannung erzeugt, die proportional zur Eingangsfrequenz ist und dem Eingang einer die digitalen Signalzustände ermittelnden Entscheiderschaltung (33) mit einstellbarer Entscheiderschwelle zugeführt wird.

2. Funkempfängerschaltung nach Anspruch 1, **dadurch gekennzeichnet, daß** als analoger Quadratursignaldemodulator (27) ein analoger Quadrikorrelator vorgesehen ist.

3. Funkempfängerschaltung nach Anspruch 1 oder 2, **dadurch gekennzeichnet, daß** in den beiden ZF-Quadratursignalpfaden (I, Q) zur Kanalfilterung selbstkalibrierende Polyphasenfilter (24) oder G_{M}C-Filter, im Anschluß daran zur Verstärkung ein begrenzender Verstärker (25), d.h. ein sogenannter Limiter, und danach ein weiteres Polyphasenfilter (26) oder ein weiteres G_{M}C-Filter zur Unterdrückung der im Limiter entstandenen Oberwellen vorgesehen sind.

4. Funkempfängerschaltung nach einem der vorhergehenden Ansprüche, **dadurch gekennzeichnet, daß** nach dem Quadratursignaldemodulator (27) zur Feststellung, ob es sich beim jeweils empfangenen digitalen Signal um eine binäre "1" oder "0" handelt, eine Entscheiderschaltung (33) mit einer Entscheiderschwelle vorgesehen ist, bei deren Festlegung ein möglicher Frequenzoffset berücksichtigt wird.

5. Funkempfängerschaltung nach einem der vorhergehenden Ansprüche, **gekennzeichnet durch** die Verwendung bei einem DECT-System.

6. Funkempfängerschaltung nach den Ansprüchen 4 und 5, **dadurch gekennzeichnet,**
**daß** zur Ermittlung der Entscheiderschwelle eine charakteristische binäre "1010"-Sequenz von 16 Bit Länge mit nachfolgender zweifacher binärer "1" der beim DECT-System spezifizierten Bursts ausgenutzt wird und dazu eine Abtast- und Halteschaltung (34) in einem Pfad zwischen dem Ausgang des Quadratursignaldemodulators (27) und einem Stelleingang der Entscheiderschaltung (33) für die Entscheiderschwelle vorgesehen ist,
**daß** die Abtast- und Halteschaltung einen an den Ausgang des Quadratursignaldemodulators angeschlossenen Tiefpaß (35), dessen Grenzfrequenz deutlich unterhalb der Modulationsfrequenz liegt, ein nachfolgendes Verzögerungsglied (37), einen Abtastschalter (37), der bei Erkennen der charakteristischen "1010"-Binärsequenz im Digitalteil geschlossen und bei Erkennen der zweifachen binären "1" in den Bursts geöffnet wird, einen Querkondensator (38) zur Speicherung eines Signalmittelwerts und eine hochohmige Pufferverstärkerstufe (39) enthält, deren Ausgang mit dem Stelleingang der Entscheiderschaltung für die Entscheiderschwelle verbunden ist, und
**daß** in einem Parallelpfad der Ausgang des Quadratursignaldemodulators mit dem Signaleingang der Entscheiderschaltung über einen Tiefpaß (40) verbunden ist, dessen Grenzfrequenz oberhalb der maximalen Modulationsfrequenz liegt.

7. Funkempfängerschaltung nach einem der vorhergehenden Ansprüche, **dadurch gekennzeichnet, daß** die Wechselstromkopplung in den beiden Quadratursignalpfaden (I, Q) durch eine oder mehrere kapazitive Kopplungen in Form von paarweise gleich groß dimensionierten Kapazitäten (C1, C2, C3, C4) gebildet ist.

## Claims

1. Radio receiver circuit, which can be integrated, for frequency-modulated digital signals using quadrature downward mixing of the RF signal, which is received via an antenna, to a low IF, IF channel filtering (following the downward mixing) by means of analog polyphase filters in the two quadrature signal paths and a downstream quadrature signal demodulator, **characterized in that** AC coupling (C1, C2, C3, C4) is provided in the two quadrature signal paths (I, Q) and
**in that** the quadrature signal demodulator (27) is an analog demodulator which produces at its output a voltage which is proportional to the input frequency and is supplied to the input of a decision circuit (33) which determines the digital signal states and has an adjustable decision threshold.

2. Radio receiver circuit according to Claim 1, **characterized in that** an analog quadricorrelator is provided as the analog quadrature signal demodulator (27).

3. Radio receiver circuit according to Claim 1 or 2, **characterized in that**, for channel filtering, the two IF quadrature signal paths (I, Q) contain self-calibrating polyphase filters (24) or G_{M}C filters, followed by a limiting amplifier (25), that is to say a so-called limiter, for amplification, and followed by a further polyphase filter (26) or a further G_{M}C filter to suppress the harmonics produced in the limiter.

4. Radio receiver circuit according to one of the preceding claims, **characterized in that**, in order to determine whether the respectively received digital signal is a binary "1" or "0", the quadrature signal demodulator (27) is followed by a decision circuit (33) having a decision threshold whose definition takes account of any possible frequency offset.

5. Radio receiver circuit according to one of the preceding claims, **characterized by** use in a DECT system.

6. Radio receiver circuit according to Claims 4 and 5, **characterized in that** a characteristic binary "1010" sequence of a length of 16 bits followed by the double binary "1" of the bursts specified for the DECT system is used to determine the decision threshold, and a sample and hold circuit (34) is provided for this purpose in a path between the output of the quadrature signal demodulator (27) and a control input of the decision circuit (33) for the decision threshold,
**in that** the sample and hold circuit contains a low-pass filter (35), which is connected to the output of the quadrature signal demodulator and whose cut-off frequency is considerably below the modulation frequency, a downstream delay element (37), a sampling switch (37), which is closed when the characteristic "1010" binary sequence is identified in the digital part and is opened when the double binary "1" is identified in the bursts, a parallel-path capacitor (38) for storing a signal mean value, and a high-impedance buffer amplifier stage (39) whose output is connected to the control input of the decision circuit for the decision threshold, and **in that**, in a parallel path, the output of the quadrature signal demodulator is connected to the signal input of the decision circuit via a low-pass filter (40) whose cut-off frequency is above the maximum modulation frequency.

7. Radio receiver circuit according to one of the preceding claims, **characterized in that** the AC coupling in the two quadrature signal paths (I, Q) is formed by one or more capacitive couplings in the form of capacitances (C1, C2, C3, C4), which are designed to be of equal size, in pairs.

## Revendications

1. Circuit radiorécepteur intégrable pour signaux numériques modulés en fréquence comportant
une conversion par abaissement en quadrature du signal, reçu par l'intermédiaire d'une antenne, à un niveau FI faible,
un filtrage de canal FI, à la suite de la conversion par abaissement, au moyen de filtres polyphasés analogiques dans les deux voies de signal en quadrature et
un démodulateur de signal en quadrature suivant,
**caractérisé en ce que** il est prévu un couplage en alternatif dans les deux voies de signal en quadrature (I, Q) et **en ce que** le démodulateur de signal en quadrature (27) est un démodulateur analogique qui génère en sortie une tension qui est proportionnelle à la fréquence d'entrée et qui est amenée à l'entrée d'un circuit de décision (33) à seuil de décision réglable déterminant les états de signal numérique.

2. Circuit radiorécepteur selon la revendication 1, **caractérisé en ce que** il est prévu un quadri-corrélateur analogique servant de démodulateur analogique de signal en quadrature.

3. Circuit radiorécepteur selon la revendication 1 ou 2, **caractérisé en ce qu'**il est prévu dans les deux voies de signal en quadrature FI (I, Q) un filtre polyphasé analogique (24) à étalonnage automatique ou bien des filtres G_{M}C en vue d'effectuer le filtrage de canal, puis un amplificateur limiteur (25), c'est-à-dire ce que l'on appelle un limiteur, en vue d'effectuer l'amplification, puis un autre filtre polyphasé (26) ou un autre filtre G_{M}C en vue de supprimer les harmoniques générées dans le limiteur.

4. Circuit radiorécepteur selon l'une des revendications précédentes, **caractérisé en ce que** il est prévu après le démodulateur de signal en quadrature (27) un circuit de décision (33) à seuil de décision en vue de déterminer si le signal numérique reçu est un « 1 » ou un « 0 » binaire, un décalage de fréquence possible étant pris en compte dans la détermination.

5. Circuit radiorécepteur selon l'une des revendications précédentes, **caractérisé par** l'utilisation dans un système DECT.

6. Circuit radiorécepteur selon des revendications 4 et 5, **caractérisé en ce que**
- pour déterminer le seuil de décision, il est utilisé une séquence binaire caractéristique « 1010 » d'une longueur de 16 bits suivie d'un double « 1 » binaire du paquet spécifié dans le système DECT, et il est prévu pour cela un circuit échantillonneur-bloqueur (34) dans une voie entre la sortie du démodulateur de signal en quadrature (27) et une entrée de réglage du circuit de décision (33) pour le seuil de décision,
- le circuit échantillonneur-bloqueur comporte
* un filtre passe-bas (35) qui est raccordé à la sortie du démodulateur de signal en quadrature et dont la fréquence de coupure est nettement inférieure à la fréquence de modulation,
* un retardateur (37) monté en aval,
* un commutateur d'échantillonnage (37) qui est fermé lors de la détection de la séquence binaire caractéristique « 1010 » dans la partie numérique et qui est ouvert lors de la détection du double « 1 » binaire dans le paquet,
* un condensateur transversal (38) destiné un mémorisé une valeur moyenne de signal et
* un étage-tampon d'amplification (39) de grande résistance, dont la sortie est reliée à l'entrée de réglage du circuit de décision pour le seuil de décision,
- et, dans une voie parallèle, la sortie du démodulateur de signal en quadrature est reliée à l'entrée de signal du circuit de décision via un filtre passe-bas (40) dont la fréquence de coupure est supérieure à la fréquence de modulation maximale.

7. Circuit radiorécepteur selon l'une des revendications précédentes, **caractérisé en ce que** le couplage en alternatif dans les deux voies de signal en quadrature (I, Q) est formé par un ou plusieurs couplages capacitifs se présentant sous la forme de condensateurs (C1, C2, C3, C4) de même dimension par paires.
